# EUROPÄISCHE PATENTSCHRIFT

(11) **EP 2 127 509 B1**
(45) Veröffentlichungstag und Bekanntmachung des Hinweises auf die Patenterteilung: **16.03.2011**
(21) Anmeldenummer: 07821870.8
(22) Anmeldetag: 26.10.2007
(51) Int. Cl.: H05K 5/06

(54) **DRUCKAUSGLEICHSELEMENT FÜR EIN GEHÄUSE UND KRAFTFAHRZEUG-ELEKTROKOMPONENTE MIT EINEM SOLCHEN DRUCKAUSGLEICHSELEMENT**
PRESSURE COMPENSATION ELEMENT FOR A HOUSING AND ELECTRICAL AUTOMOTIVE COMPONENT COMPRISING SAID PRESSURE COMPENSATION ELEMENT
ÉLÉMENT D'ÉQUILIBRAGE DE PRESSION POUR BOÎTIER ET COMPOSANT ÉLECTRIQUE DE VÉHICULE À MOTEUR COMPRENANT UN TEL ÉLÉMENT D'ÉQUILIBRAGE DE PRESSION

(30) Priorität: 22.12.2006 DE 102006061280; 16.03.2007 DE 102007012703
(43) Veröffentlichungstag der Anmeldung: 02.12.2009
(60) Teilanmeldung: 10186637.4
(73) Patentinhaber: Robert Bosch GmbH, 70442 Stuttgart (DE)
(72) Erfinder: DIETRICH, Jan, 77815 Buehl (DE); KASTINGER, Guenter, 76571 Gaggenau-Sulzbach (DE); HUESGES, Mario, 77830 Buehlertal (DE); KUDERER, Alexander, 77770 Durbach (DE); LAUK, Detlef, 77871 Renchen (DE); SCHNEIDER, Wolfgang, 76547 Sinzheim (DE); DUDEK, Alexander, 77656 Offenburg (DE)
(86) Internationale Anmeldenummer: PCT/EP2007/061507
(87) Internationale Veröffentlichungsnummer: WO 2008/077667

(56) Entgegenhaltungen:
- EP-A- 0 377 067
- EP-A- 1 921 020
- WO-A-2006/031735
- DE-A1- 3 707 050
- DE-T2- 60 026 755
- US-A- 4 544 166
- US-A1- 2002 190 485

## Beschreibung

### Stand der Technik

Die Erfindung betrifft ein Druckausgleichselement, welches an einer Anbringöffnung, insbesondere Entlüftungsdom, eines Gehäuses anbringbar ist. Die Erfindung betrifft außerdem eine Kraftfahrzeug-Elektrokomponente, insbesondere ein Getriebegehäuse eines Wischermotors, die ein derartiges Druckausgleichselement umfasst.

Bei vielen Elektrokomponenten, die zur Abschottung gegen Umwelteinflüsse ein geschlossenes Gehäuse, z. B. das Getriebegehäuse eines Wischermotors, aufweisen, ist es erforderlich, im Gehäuse eine Öffnung vorzusehen, die beim Auftreten einer Temperaturdifferenz einen Druckausgleich zwischen Innen und Außen ermöglicht. Dieses Entlüftungsorgan, typischerweise ein kleiner, in die Gehäusewand integrierter, offener Zylinder, ein so genannter Entlüftungsdom, wird häufig mit weiteren Komponenten, insbesondere einem Labyrinth, einer Membran und einer auf das aus dem Gehäuse herausragende Ende des Doms aufsetzbaren Schutzkappe, ergänzt. Diese Zusatzkomponenten der Druckausgleichsanordnung sollen den mit dem Luftaustausch grundsätzlich auch möglich gewordenen Eintritt von Wasser, Staub usw. durch die Gehäuseöffnung in den Innenraum des Gehäuses weitestgehend verhindern.

Druckausgleichsanordnungen für Gehäuse sind in zahlreichen Ausführungsformen bekannt. Aus der DE 600 26 755 T2 ist eine luftdurchlässige Kappe mit integriertem Filterelement bekannt, die an der Öffnung einer Kfz-Elektrokomponente angebracht ist. Die bekannte Kappe umfasst ein im Wesentlichen zylindrisch ausgebildetes Abdeckungselement, in das ein zylindrischer Adapter, der eine axiale Bohrung aufweist, eingesetzt ist. Der Luftdurchlass ist so ausgebildet, dass die aus dem Inneren eines Gehäuses beispielsweise ausströmende Luft durch die Axialbohrung des Adapters strömt, das luftdurchlässige Filterelement durchdringt, am geschlossenen Ende (Bodenfläche) des Abdeckungselementes umgelenkt wird und zwischen der Außenwand des Adapters und der Innenwand des Abdeckungselementes bis zum freien Ende der Wandung des Abdeckungselementes weiterströmt und dort austritt. Um den zylindrischen Adapter in das zylindrische Abdeckungselement einsetzen, positionieren und fixieren und gleichzeitig den beschriebenen Luftdurchlass in der Peripherie der Kappe realisieren zu können, sind eine Vielzahl von gleichmäßig entlang des Umfangs des Adapters verteilte Vorsprünge vorgesehen, wobei ein Luftdurchlass zwischen den Vorsprüngen ausgebildet wird. Diese Maßnahmen sollen eine kompakte Form und einen kostengünstigen Aufbau der luftdurchlässigen Kappe gewährleisten.

Die bekannte luftdurchlässige Kappe kann aber nicht, insbesondere nicht in allen Einbausituationen, alle an sie zu stellenden Anforderungen erfüllen. Da die Einbauposition, beispielsweise an einer bestimmten Stelle des Getriebegehäuses, bzw. auch die Einbaulage in der Praxis meist vorgegeben sind, sollte die Kappe einerseits größenmäßig an die gegebenen, oft sehr beengten Raumverhältnisse anpassbar sein. Die bekannte Kappe mit koaxialer Struktur scheint vom Bauprinzip her jedoch wenig Spielraum für eine weitere Verkleinerung zu bieten. Außerdem besteht bei einer Einbaulage der bekannten Kappe mit nach 'unten', das heißt in Richtung der Erdanziehung, abragenden Entlüftungsdom die Gefahr, dass sich Spritzwasser - wie bei einem umgedrehten Regenschirm - im Bodenbereich des Abdeckungselementes staut und dadurch dem Filterelement seine Luftdurchlässigkeit nimmt.

### Offenbarung der Erfindung

Ein erfindungsgemäßes Druckausgleichselement ist jeweils in den Merkmalen eines der unabhängigen Ansprüche 1, 2 oder 4 angegeben. Außerdem ist eine erfindungsgemäße, ein derartiges Druckausgleichselement umfassende Kraftfahrzeug-Elektrokomponente in Anspruch 8 angegeben. Weiterbildungen und bevorzugte Maßnahmen ergeben sich aus den Unteransprüchen.

Allen drei unabhängigen erfindungsgemäßen Varianten des Druckausgleichselementes gemeinsam ist ein topfförmiges Abdeckungselement mit einer Bodenfläche und einer Wandung, ein in das Abdeckungselement eingesetzter Adapter aus elastischem Werkstoff, der eine durchgehende Bohrung aufweist, deren zur Bodenfläche des Abdeckungselementes gerichtete Öffnung von einem Filterelement abgedeckt ist, sowie ein Luftdurchlass, der zwischen der Innenwand des Abdeckungselementes und der Außenwand des Adapters sowie zwischen der Bodenfläche des Abdeckungselementes und der Bohrung des Adapters ausgebildet ist.

Bei der Variante gemäß Anspruch 1 ist weiterhin der Adapter mit einer entlang seines Umfangs durch einen einzelnen Vorsprung unterbrochenen, asymmetrischen Außenkontur ausgebildet, wobei der Vorsprung mit der Innenwand des Abdeckungselementes in Kontakt steht, so dass zu beiden Seiten des Vorsprunges ein Luftdurchlass ausgebildet ist.

Bei der dazu alternativen Variante gemäß Anspruch 2 hingegen ist der Adapter mit einer entlang seines Umfangs durch zwei axiale Nuten, zwischen denen ein Zahn gebildet ist, unterbrochenen, asymmetrischen Außenkontur ausgebildet, wobei die Außenkontur im Bereich der zwei Nuten nicht mit der Innenwand des Abdeckungselementes in Kontakt steht, so dass in den beiden Nuten ein Luftdurchlass ausgebildet ist.

Durch die jeweils spezielle asymmetrische Außenkontur weist das erfindungsgemäße Druckausgleichselement gemäß den beiden genannten Varianten nicht mehr die aus dem Stand der Technik bekannte raumfordernde Koaxial-Struktur auf; andererseits ist trotz verringertem Bauraumbedarf des Druckausgleichselementes dennoch zwischen der Abdeckungselement-Innenwand und der Adapter-Außenwand ein ausreichender Luftdurchlass sichergestellt.

Gemäß einer vorteilhaften Ausführungsform der in Anspruch 2 beanspruchten Lösung kann der Adapter oder der Adapter und das Abdeckungselement - abgesehen von den Nuten im Adapter - eine Außenkontur in Form eines Zylinderumfangs oder eines regelmäßigen Polygons aufweisen. Dadurch kann, insbesondere wenn die Form des Abdeckungselementes der Form des Adapters folgt, eine weitere Anpassung an die gegebenen Raumverhältnisse erreicht werden.

Bei einer vorteilhaften Variante ist über die oben genannten, gemeinsamen Merkmale hinaus vorgesehen, dass der Übergangsbereich der Bodenfläche zur Wandung des Abdeckungselementes mindestens eine Ausnehmung aufweist, die in einem nicht dem Luftdurchlass zwischen der Innenwand des Abdeckungselementes und der Außenwand des Adapters dienenden Segment des Umfangs des Abdeckungselementes angeordnet ist. Dadurch kann bei einem 'kopfüber' eingebauten Druckausgleichselement gestautes Wasser bei gleichzeitig uneingeschränkt vorhandener Luftdurchlässigkeit des Druckausgleichselementes abfließen.

Gemäß einer Ausführungsform dieser letztgenannten Lösung ist es von besonderem Vorteil, dass im zwischen der Bodenfläche des Abdeckungselementes und dem Filterelement gebildeten Zwischenraum ein Labyrinthsystem vorgesehen ist, das jeweils ein der jeweiligen Ausnehmung zugewandtes, den direkten Zugang von der Ausnehmung zum Zentrum des Zwischenraumes blockierendes, Wandelement umfasst. Diese Wandelemente schaffen, ohne die Abflussöffnung bzw. einen Luftaustausch zu behindern, einen geschützten, indirekten Zugang ins Innere des Druckausgleichselementes, der insbesondere Schutz vor spitzen Gegenständen und vor Staub beziehungsweise Verschmutzung gewährleistet.

Bei einer vorteilhaften Variation ist - zur Verbesserung des Wasserabflusses bzw. des Luftaustausches, auch bei aufgesetztem, eng an einem Gehäuse anliegenden Druckausgleichselement - am freien Ende der Wandung des Abdeckungselementes mindestens eine Aussparung vorgesehen, die jeweils im gleichen Segment des Umfangs wie die zugehörige Ausnehmung angeordnet ist.

Bei allen Varianten des erfindungsgemäßen Druckausgleichselementes ist es vorteilhaft, dass das Filterelement durch eine poröse, luftdurchlässige und wasserabweisende Membran gebildet ist, und dass die Membran durch in der Bohrung des Adapters kreuzförmig angebrachte Stege gestützt ist, so dass es bei Eindringen von Feuchtigkeit nicht zu einer die Funktion beeinträchtigenden Sickenbildung der Membran kommt.

Die erfindungsgemäße Kraftfahrzeug-Elektrokomponente umfasst ein Druckausgleichselement der oben beschriebenen Art. Gemäß einer Ausführungsform ist es dabei vorteilhaft, das Druckausgleichselement an einen Entlüftungsdom anzubringen, wobei der Entlüftungsdom zur Erschwerung des Eindringens von Wasser einen zur Elektrokomponente hin gelegenen Abschnitt mit rundem Innenquerschnitt und zum Druckausgleichselement hin einen Abschnitt mit eckigem Innenquerschnitt aufweist. Das erfindungsgemäße Druckausgleichselement ist also mit einem Entlüftungsdom einer Elektrokomponente kombinierbar, der so ausgestaltet ist, dass der Entlüftungsdom auch im noch nicht durch das Druckausgleichselement verschlossenen Zustand besonders wassergeschützt ist. Wenn es sich bei der Kfz-Komponente um ein Getriebegehäuse eines Wischermotors handelt, eröffnet sich gemäß einer weiteren Ausführungsform auch die Möglichkeit, die aus dem Getriebegehäuse des Wischermotors austretende Abtriebswelle als zum Druckausgleich des Wischermotors dienende Hohlwelle auszubilden, an deren aus dem Getriebegehäuse herausragenden Ende das Druckausgleichselement angebracht ist.

### Kurze Beschreibung der Zeichnungen

Figur 1 zeigt eine perspektivische Ansicht eines erfindungsgemäßen Druckausgleichselementes mit transparent dargestellten Abdeckungselement und darin eingesetzten asymmetrischen Adapter,
Figur 2 zeigt eine Draufsicht auf einen schematisch dargestellten weiteren asymmetrischen Adapter für ein Druckausgleichselement gemäß der Erfindung,
Figur 3 zeigt eine Explosionsdarstellung eines erfindungsgemäßen Druckausgleichselementes mit symmetrischem Adapter und mit Entlüftungsdom,
Figur 4 zeigt das Druckausgleichselement gemäß Figur 3 in einer teilweise geschnittenen Darstellung,
Figur 5 zeigt die Ansicht einer erfindungsgemäßen Anordnung mit einem an einem Getriebegehäuse eines Wischermotors angebrachten Druckausgleichselement,
Figur 6 zeigt eine weitere Anordnung aus Getriebegehäuse und Druckausgleichselement.

### Ausführungsform der Erfindung

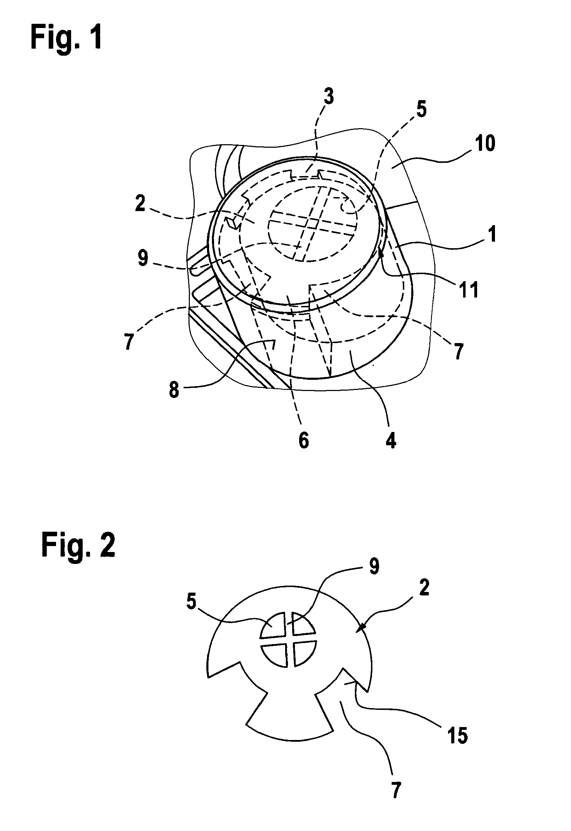

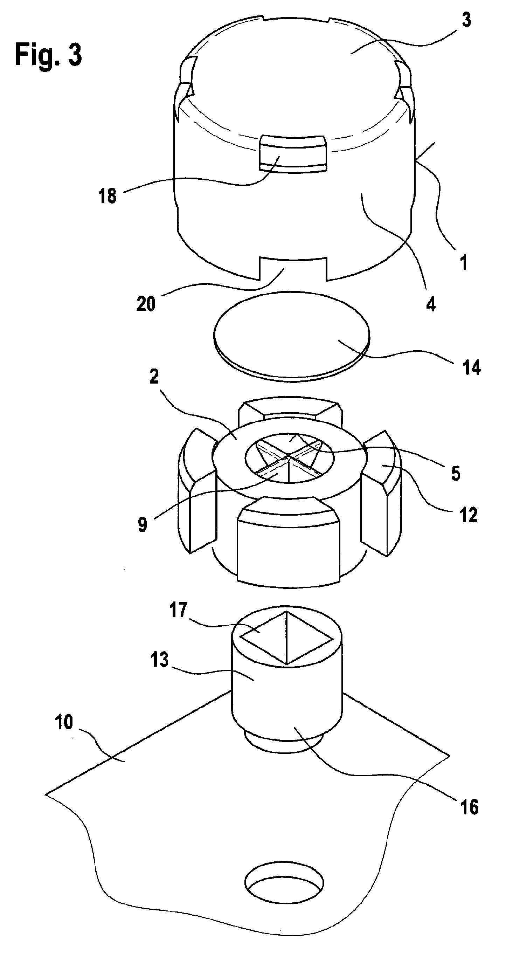

In Figur 1 ist eine Ausführungsform eines Druckausgleichselementes gemäß der Erfindung dargestellt, bei der zunächst ein topfförmiges Abdeckungselement 1 mit einer Bodenfläche 3 und einer zylindrischen Wandung 4 zu erkennen ist. Das Abdeckungselement 1 ist in Figur 1 transparent dargestellt, um den eingesetzten Adapter 2 erkennen zu können. Der Adapter 2 besteht aus elastischem Werkstoff und weist eine durchgehende Bohrung 5 auf, deren zur Bodenfläche 3 des Abdeckungselementes 1 gerichtete Öffnung kreuzförmige Stege 9 aufweist. Die Stege 9 dienen, wie im Zusammenhang mit Figur 3 noch näher beschrieben wird, zur Stützung eines die Öffnung abdeckenden, hier nicht dargestellten Filterelementes.

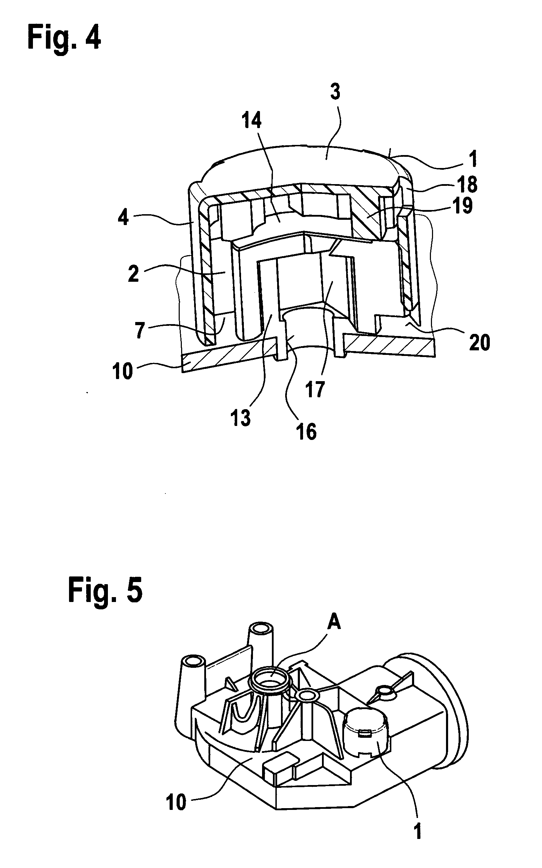

Der Adapter 2 ist mit dem unteren Ende seiner axialen Bohrung 5 auf das zu entlüftende Getriebegehäuse 10, insbesondere auf einen in die Bohrung 5 hineinragenden Entlüftungsdom (vgl. Figur 3), aufgesetzt. Außerdem ist der Adapter 2 im Abdeckungselement 1 positioniert und radial fixiert. Der Adapter 2 weist ein zentrales Teil mit einer im wesentlichen zylindrischen Außenkontur auf, wobei jedoch vom zentralen Teil ein einzelner Vorsprung 6 abragt, so dass die Außenwand des Adapters 2 eine insgesamt asymmetrische Außenkontur aufweist. Beim Befestigen des Adapters 2 im Abdeckungselement 1 wird die äußere Fläche 8 des Vorsprunges 6 gegen die Innenwand (der Wandung 4) des Abdeckungselementes 1 gedrückt. Weiterhin wird insbesondere auch die der äußeren Fläche 8 gegenüberliegende, 'rückwärtige' Fläche des zentralen Teils des Adapters 2 gegen die Innenwand (der Wandung 4) des Abdeckungselementes 1 gedrückt. Auch wenn sich der Abstand zwischen der Adapter-Außenwand und der Abdeckungselement-Innenwand seitlich vom Vorsprung 6 weg zunehmend verengt, bleibt in jedem Fall links und rechts des Vorsprunges 6 ein ausreichend großer Luftdurchlass 7, um den Luftaustausch im Luftkanal zwischen dem Entlüftungsdom, der Bohrung 5, dem Zwischenraum zwischen dem oberen Ende der Bohrung 5 und dem abgeschlossenen Ende (Bodenfläche 3) des Abdeckungselementes 1 und schließlich der unverschlossenen, unteren (getriebegehäuseseitigen) Peripherie des Druckausgleichselementes zu gewährleisten. Im eingesetzten Zustand gelangen im Bodenbereich des Abdeckungselementes 1 vorgesehene Sockel in Kontakt mit der bodenseitigen Stirnseite des Adapters 2, um den genannten Zwischenraum zu bilden. (Der Zwischenraum kann auch durch das weiter unten, im Zusammenhang mit Figur 4, beschriebene Labyrinthsystem gebildet werden.)

Der Bauraumbedarf des asymmetrischen Adapters 2 - und damit auch der des Druckausgleichselementes - ist ersichtlich kleiner als bei einem symmetrischen Adapter mit beispielsweise vier am Umfang verteilten Vorsprüngen 12, vgl. Figur 3. Hinsichtlich der mechanischen Stabilität noch vorteilhafter ist die in Figur 2 schematisch dargestellte weitere, ebenfalls kleinbauende Ausführungsform eines asymmetrischen Adapters 2, bei dem der Luftdurchlass 7 zwischen der Adapter-Außenwand und der Abdeckungselement-Innenwand nicht seitlich von einem einzelnen Vorsprung oder zwischen mehreren Vorsprüngen erfolgt, sondern bei dem der Luftdurchlass 7 - in Form von zwei Nuten 15 - quasi nach innen in den zentralen Teil des Adapters 2 verlegt ist. Hinzu kommt bei dieser weiteren asymmetrischen Ausführungsform, dass der Adapter 2 im Abdeckungselement 1 besonders exakt positionierbar ist und dass keine Spalte 11, vgl. Figur 1, gebildet werden, in denen sich Wasser halten könnte.

Wie in den Figuren 1 und 2 erkennbar, kann die Bohrung 5 des in das Abdeckungselement 1 eingesetzten Adapters 2 exzentrisch zum asymmetrischen Adapter 2 beziehungsweise zum Abdeckungselement 1 angeordnet sein, so dass sich vorteilhaft ein weiterer Spielraum in der relativen Position von Entlüftungsdom 13 bzw. Druckausgleichselement zur Umgebung ergibt.

Bei der in Figur 3 dargestellten weiteren Ausführungsform des erfindungsgemäßen Druckausgleichselementes sind beispielhalber vier Vorsprünge 12 gleichmäßig verteilt am Umfangs des zentralen Teils des Adapters 2 angebracht, so dass ein hinsichtlich der Außenkontur insgesamt symmetrischer Adapter 2 resultiert. Der Entlüftungsdom 13 ist - entgegen der aus Gründen der Übersichtlichkeit gewählten Darstellung - typischerweise integral mit dem in der Figur 3 nur schematisch angedeuteten Getriebegehäuse 10 ausgeführt.

Das aus dem symmetrischen Adapter 2, einem luftdurchlässigen Filterelement - der Membran 14 - und dem Abdeckungselement 1 zusammengesetzte Druckausgleichselement wird auf den Entlüftungsdom 13 aufgesetzt. Der Entlüftungsdom 13 weist einen zum Getriebegehäuse 10 hin gelegenen Abschnitt 16 mit rundem Innenquerschnitt und zum Druckausgleichselement hin einen Abschnitt mit (recht)eckigem Innenquerschnitt 17 auf. Diese Formgebung bzw. deren Hintereinanderanordnung ist zur Vermeidung von Wasserbrücken durch inhomogene Oberflächenspannungen geeignet, so dass ein mögliches Eindringen von Wasser (insbesondere bei einem noch nicht durch ein Druckausgleichselement verschlossenen Entlüftungsdom 13) verhindert wird.

Der Adapter 2 besteht aus elastischem Werkstoff, so dass er mit seiner Bohrung 5 relativ leicht über den Dom 13 gestülpt bzw. aufgepresst werden kann. Auf der oberen Stirnseite des Adapters 2 ist als Filterelement eine poröse, luftdurchlässige und wasserundurchlässige Membrane 14 befestigt, wobei die Membrane durch in der Bohrung 5 des Adapters 2 kreuzförmig angebrachte Stege 9 gestützt ist. Dadurch wird eine Faltung der Membrane 14 verhindert. Die kreuzförmigen Stege 9 können, wie in Figur 3 angedeutet, leicht gewölbt sein, so dass keine Sickenbildung erfolgt, sondern das Wasser abfließen kann.

Im Übergangsbereich zwischen der Bodenfläche 3 des Abdeckungselementes 1 zu seiner Wandung ist mindestens eine Ausnehmung 18 vorgesehen, die in einem nicht dem Luftdurchlass 7 zwischen der Innenwand des Abdeckungselementes 1 und der Außenwand des Adapters 2 dienenden Segment des Abdeckungselementes 1 angeordnet ist. Gestautes Wasser in einem 'umgedrehten' Druckausgleichselement kann durch die Ausnehmung 18 abfließen.

Typischerweise liegt das Druckausgleichselement - um die Entlüftung zu ermöglichen und um kein Wasser durch Kapillarwirkung anzuziehen - nicht völlig auf dem Gehäuse 10 auf. Selbst dann kann die Entlüftung und der Wasserabfluss dadurch gewährleistet werden, dass am freien Ende der Wandung 4 des Abdeckungselementes 1 mindestens eine Aussparung 20 vorgesehen ist, die jeweils im gleichen Segment wie die zugehörige Ausnehmung 18 angeordnet ist.

Die Membrane 14 - und der Luftkanal insgesamt - wird über das Abdeckungselement 1 geschützt. Dieses hat ein Labyrinthsystem, vgl. Figur 4, welches immer eine Luftab/zufuhr, Schutz vor spitzen Gegenständen, Schutz vor Staub bzw. Verschmutzung und Wasserablauf unabhängig von der Einbaulage gewährleistet. Außerdem erfolgt über das Abdeckungselement 1 eine Pressung auf den Adapter 2, welches ein Lösen vom Getriebegehäuse 10 verhindert. Im einzelnen ist vorgesehen, dass im Zwischenraum zwischen der Bodenfläche 3 des Abdeckungselementes 1 und dem Filterelement 14 ein Labyrinthsystem vorgesehen ist, das jeweils ein der jeweiligen Ausnehmung 18 zugewandtes, den direkten Zugang von außen zum Zentrum des Zwischenraumes blockierendes, Wandelement 19 umfasst. Dieses Wandelement 19 ist ein relativ massives Teil, das säulenartig auf die Membrane 14 drückt und gleichzeitig den stirnseitigen Zwischenraum zwischen dem Adapter 2 und der Bodenfläche 3 abstützt. Die beschriebene Ausführung mit den Ausnehmungen 18 bzw. dem Labyrinthsystem ist auch im Zusammenhang mit den in Figur 1 beschriebenen asymmetrischen Ausführungsformen vorteilhaft einsetzbar.

Bei einer kostengünstigen Entlüftungsvariante ist die aus dem Getriebegehäuse 10 des Wischermotors austretende Abtriebswelle (vgl. Figur 5, die nur die entsprechende Öffnung A im Gehäuse 10 zeigt) als zum Druckausgleich des Wischermotors dienende Hohlwelle ausgebildet, an deren aus dem Getriebegehäuse 10 herausragenden Ende das Druckausgleichselement angebracht ist.

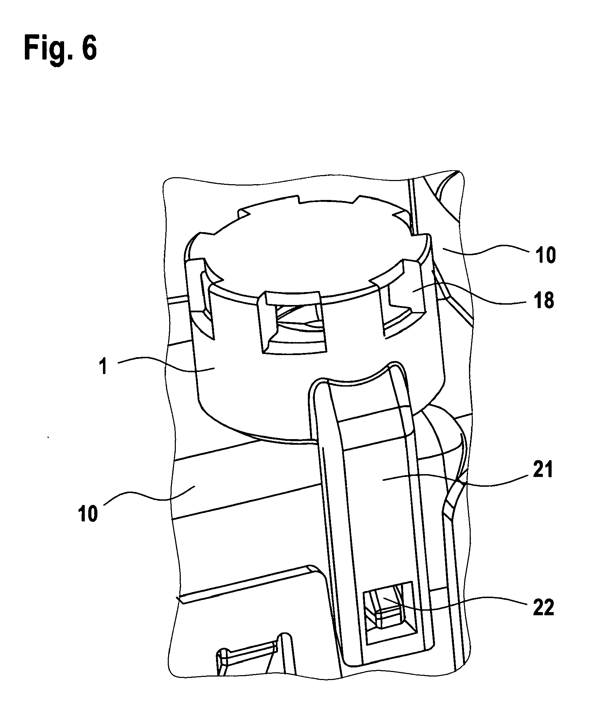

Figur 6 zeigt eine weitere Anordnung bestehend aus einem Getriebegehäuse 10 mit einer (hier nicht erkennbaren) Anbringöffnung oder einem Entlüftungsdom, und einem darauf aufgesetzten Druckausgleichselement, welches beispielhalber mit sechs Ausnehmungen 18 im Abdeckungselement 1 (und entsprechenden sechs Vorsprüngen 12 am Adapter 2) ausgestattet ist. Anders als bei den bisherigen Ausführungsformen wird ein Lösen des Druckausgleichselementes vom Getriebegehäuse 10 nicht nur durch einen Kraftschluss (Pressung) verhindert, sondern zusätzlich durch einen Formschluss über einen Rasthaken 21 am Abdeckungselement 1 und eine Rastnase 22 am Getriebegehäuse 10.

## Patentansprüche

1. Druckausgleichselement, welches an einer Anbringöffnung insbesondere Entlüftungsdom, eines Gehäuses anbringbar ist, umfassend:
- ein topfförmiges Abdeckungselement (1) mit einer Bodenfläche (3) und einer Wandung (4),
- einen in das Abdeckungselement (1) eingesetzten Adapter (2) aus elastischem Werkstoff, der eine durchgehende Bohrung (5) aufweist, deren zur Bodenfläche (3) des Abdeckungselementes (1) gerichtete Öffnung von einem Filterelement (14) abgedeckt ist,
- einen Luftdurchlass (7), der zwischen der Innenwand des Abdeckungselementes (1) und der Außenwand des Adapters (2) sowie zwischen der Bodenfläche (3) des Abdeckungselementes und der Bohrung (5) des Adapters (2) ausgebildet ist,
- wobei der Adapter (2) mit einer entlang seines Umfangs durch einen einzelnen Vorsprung (6) unterbrochenen, asymmetrischen Außenkontur ausgebildet ist, und wobei der Vorsprung (6) mit der Innenwand des Abdeckungselementes (1) in Kontakt steht, so dass zu beiden Seiten des Vorsprunges (6) ein Luftdurchlass (7) ausgebildet ist.

2. Druckausgleichselement, welches an einer Anbringöffnung insbesondere Entlüftungsdom, eines Gehäuses anbringbar ist, umfassend:
- ein topfförmiges Abdeckungselement (1) mit einer Bodenfläche (3) und einer Wandung (4),
- einen in das Abdeckungselement (1) eingesetzten Adapter (2) aus elastischem Werkstoff, der eine durchgehende Bohrung (5) aufweist, deren zur Bodenfläche (3) des Abdeckungselementes (1) gerichtete Öffnung von einem Filterelement (14) abgedeckt ist,
- einen Luftdurchlass (7), der zwischen der Innenwand des Abdeckungselementes (1) und der Außenwand des Adapters (2) sowie zwischen der Bodenfläche (3) des Abdeckungselementes und der Bohrung (5) des Adapters (2) ausgebildet ist,
- wobei der Adapter (2) mit einer entlang seines Umfangs durch zwei axiale Nuten (15), zwischen denen ein Zahn gebildet ist, unterbrochenen, asymmetrischen Außenkontur ausgebildet ist, und wobei die Außenkontur im Bereich der zwei Nuten (15) nicht mit der Innenwand des Abdeckungselementes (1) in Kontakt steht, so dass in den beiden Nuten (15) ein Luftdurchlass (7) ausgebildet ist.

3. Druckausgleichselement nach Anspruch 2, **dadurch gekennzeichnet, dass** der Adapter (2) oder der Adapter (2) und das Abdeckungselement (1) eine Außenkontur in Form eines - abgesehen von den Nuten (15) im Adapter (2) - Zylinderumfangs oder eines regelmäßigen Polygons aufweisen.

4. Druckausgleichselement nach einem der Ansprüche 1 bis 3, **dadurch gekennzeichnet, dass** im Übergangsbereich der Bodenfläche (3) zur Wandung (4) des Abdeckungselementes (1) mindestens eine Ausnehmung (18) vorgesehen ist, die in einem nicht dem Luftdurchlass (7) zwischen der Innenwand des Abdeckungselementes (1) und der Außenwand des Adapters (2) dienenden Segment des Umfangs des Abdeckungselementes (1) angeordnet ist.

5. Druckausgleichselement nach Anspruch 4, **dadurch gekennzeichnet, dass** im Zwischenraum zwischen der Bodenfläche (3) des Abdeckungselementes (1) und dem Filterelement (14) ein Labyrinthsystem vorgesehen ist, das jeweils ein der jeweiligen Ausnehmung (18) zugewandtes, den direkten Zugang von der Ausnehmung (18) zum Zentrum des Zwischenraumes blockierendes, Wandelement (19) umfasst.

6. Druckausgleichselement nach Anspruch 4 oder 5, **dadurch gekennzeichnet, dass** am freien Ende der Wandung (4) des Abdeckungselementes (1) mindestens eine Aussparung (20) vorgesehen ist, die jeweils im gleichen Segment wie die zugehörige Ausnehmung (18) angeordnet ist.

7. Druckausgleichselement nach einem der Ansprüche 1 bis 6, **dadurch gekennzeichnet, dass** das Filterelement (14) durch eine poröse, luftdurchlässige und wasserabweisende Membran (14) gebildet ist, und dass die Membran (14) durch in der Bohrung (5) des Adapters (2) kreuzförmig angebrachte Stege (9) gestützt ist.

8. Kraftfahrzeug-Elektrokomponente, insbesondere Getriebegehäuse (10) eines Wischermotors, die ein Druckausgleichselement nach Anspruch 1, oder 2 umfasst.

9. Kraftfahrzeug-Elektrokomponente nach Anspruch 8, **dadurch gekennzeichnet, dass** das Druckausgleichselement an einen Entlüftungsdom (13) angebracht ist, wobei der Entlüftungsdom (13) einen zur Elektrokomponente hin gelegenen Abschnitt (16) mit rundem Innenquerschnitt und zum Druckausgleichselement hin einen Abschnitt mit eckigem Innenquerschnitt (17) aufweist.

10. Kraftfahrzeug-Elektrokomponente nach Anspruch 8, **dadurch gekennzeichnet, dass** die aus dem Getriebegehäuse (10) des Wischermotors austretende Abtriebswelle als zum Druckausgleich des Wischermotors dienende Hohlwelle ausgebildet ist, an deren aus dem Getriebegehäuse (10) herausragenden Ende das Druckausgleichselement angebracht ist.

11. Kraftfahrzeug-Elektrokomponente nach Anspruch 8, **dadurch gekennzeichnet, dass** das Druckausgleichselement an der Anbringöffnung durch Presspassung in der Adapterbohrung (5) angebracht ist, und dass das Druckausgleichselement zusätzlich mit einem Rasthaken (21) als Gegenstück zu einer am Gehäuse (10) vorgesehenen Rastnase (22) ausgebildet ist, wobei der Rasthaken (21) formschlüssig an der Rastnase (22) anliegt.

## Claims

1. Pressure compensation element which can be fitted on a fitting opening, in particular ventilation dome, of a housing, comprising:
- a cup-shaped covering element (1) with a base surface (3) and a wall (4),
- an adapter (2) which is made from elastic material, is inserted into the covering element (1) and has a continuous bore (5), and the opening of which, which opening faces the base surface (3) of the covering element (1), is covered by a filter element (14),
- and an air passage (7) which is formed between the inner wall of the covering element (1) and the outer wall of the adapter (2) and between the base surface (3) of the covering element and the bore (5) in the adapter (2),
- wherein the adapter (2) is formed with an asymmetrical outer contour which is interrupted along the circumference thereof by an individual projection (6), and wherein the projection (6) is in contact with the inner wall of the covering element (1) such that an air passage (7) is formed on both sides of the projection (6).

2. Pressure compensation element which can be fitted on a fitting opening, in particular ventilation dome, of a housing, comprising:
- a cup-shaped covering element (1) with a base surface (3) and a wall (4),
- an adapter (2) which is made from elastic material, is inserted into the covering element (1) and has a continuous bore (5), and the opening of which, which opening faces the base surface (3) of the covering element (1), is covered by a filter element (14),
- and an air passage (7) which is formed between the inner wall of the covering element (1) and the outer wall of the adapter (2) and between the base surface (3) of the covering element and the bore (5) in the adapter (2),
- wherein the adapter (2) is formed with an asymmetrical outer contour which is interrupted along the circumference thereof by two axial grooves (15) between which a tooth is formed, and wherein the outer contour is not in contact in the region of the two grooves (15) with the inner wall of the covering element (1), and therefore an air passage (7) is formed in the two grooves (15).

3. Pressure compensation element according to Claim 2, **characterized in that** the adapter (2) or the adapter (2) and the covering element (1) has/have an outer contour in the form of a cylinder circumference or a regular polygon - apart from the grooves (15) in the adapter (2).

4. Pressure compensation element according to one of Claims 1 to 3, **characterized in that** at least one recess (18) is provided in the transition region of the base surface (3) to the wall (4) of the covering element (1), said recess being arranged in a segment of the circumference of the covering element (1) not used for the air passage (7) between the inner wall of the covering element (1) and the outer wall of the adapter (2).

5. Pressure compensation element according to Claim 4, **characterized in that** a labyrinth system is provided in the intermediate space between the base surface (3) of the covering element (1) and the filter element (14), the labyrinth system in each case comprising a wall element (19) which faces the respective recess (18) and blocks the direct access from the recess (18) to the centre of the intermediate space.

6. Pressure compensation element according to Claim 4 or 5, **characterized in that** at least one cutout (20) which is arranged in each case in the same segment as the associated recess (18) is provided at the free end of the wall (4) of the covering element (1).

7. Pressure compensation element according to one of Claims 1 to 6, **characterized in that** the filter element (14) is formed by a porous, air-permeable and water-repelling diaphragm (14), and **in that** the diaphragm (14) is supported by webs (9) mounted in a cross-shaped manner in the bore (5) in the adapter (2).

8. Electrical automotive component, in particular gear casing (10) of a wiper motor, which comprises a pressure compensation element according to Claim 1 or 2.

9. Electrical automotive component according to Claim 8, **characterized in that** the pressure compensation element is fitted onto a ventilation dome (13), the ventilation dome (13) having a section (16) which faces the electrical component and has a round internal cross section and a section having an angular internal cross section (17) facing the pressure compensation element.

10. Electrical automotive component according to Claim 8, **characterized in that** the output shaft emerging from the gear casing (10) of the wiper motor is designed as a hollow shaft which serves for the pressure compensation of the wiper motor, and the pressure compensation element is fitted to that end of the hollow shaft which projects out of the gear casing (10).

11. Electrical automotive component according to Claim 8, **characterized in that** the pressure compensation element is fitted on the fitting opening by means of a press fit in the adapter bore (5), and **in that** the pressure compensation element is additionally designed with a latching hook (21) as a counterpart to a latching lug (22) provided on the casing (10), the latching hook (21) bearing in a form-fitting manner against the latching lug (22).

## Revendications

1. Elément d'équilibrage de la pression, qui peut être appliqué sur une ouverture de montage, notamment un dôme de ventilation, d'un boîtier, comprenant :
- un élément de recouvrement en forme de pot (1) avec une surface de fond (3) et une paroi (4),
- un adaptateur (2) en matériau élastique inséré dans l'élément de recouvrement (1), qui présente un alésage traversant (5), dont l'ouverture orientée vers la surface de fond (3) de l'élément de recouvrement (1) est recouverte par un élément de filtre (14),
- un passage d'air (7), qui est réalisé entre la paroi interne de l'élément de recouvrement (1) et la paroi externe de l'adaptateur (2) ainsi qu'entre la surface de fond (3) de l'élément de recouvrement et l'alésage (5) de l'adaptateur (2),
- l'adaptateur (2) étant réalisé avec un contour extérieur asymétrique, interrompu le long de sa périphérie par une saillie unique (6), la saillie (6) étant en contact avec la paroi interne de l'élément de recouvrement (1), de sorte qu'un passage d'air (7) soit réalisé des deux côtés de la saillie (6).

2. Elément d'équilibrage de la pression, qui peut être appliqué sur une ouverture de montage, notamment un dôme de ventilation, d'un boîtier, comprenant :
- un élément de recouvrement en forme de pot (1) avec une surface de fond (3) et une paroi (4),
- un adaptateur (2) en matériau élastique inséré dans l'élément de recouvrement (1), qui présente un alésage traversant (5), dont l'ouverture orientée vers la surface de fond (3) de l'élément de recouvrement (1) est recouverte par un élément de filtre (14),
- un passage d'air (7), qui est réalisé entre la paroi interne de l'élément de recouvrement (1) et la paroi externe de l'adaptateur (2) ainsi qu'entre la surface de fond (3) de l'élément de recouvrement et l'alésage (5) de l'adaptateur (2),
- l'adaptateur (2) étant réalisé avec un contour extérieur asymétrique, interrompu le long de sa périphérie par deux rainures axiales (15), entre lesquelles est formée une dent, le contour extérieur, dans la région des deux rainures (15), n'étant pas en contact avec la paroi intérieure de l'élément de recouvrement (1), de sorte qu'un passage d'air (7) soit réalisé dans les deux rainures (15).

3. Elément d'équilibrage de la pression selon la revendication 2, **caractérisé en ce que** l'adaptateur (2) ou l'adaptateur (2) et l'élément de recouvrement (1) présentent un contour extérieur en forme de périphérie cylindrique ou de polygone régulier - à l'exception des rainures (15) dans l'adaptateur (2).

4. Elément d'équilibrage de la pression selon l'une quelconque des revendications 1 à 3, **caractérisé en ce que**, dans la région de transition de la surface de fond (3) à la paroi (4) de l'élément de recouvrement (1), est prévu au moins un logement (18), qui est disposé dans un segment de la périphérie de l'élément de recouvrement (1) ne servant pas au passage d'air (7) entre la paroi interne de l'élément de recouvrement (1) et la paroi externe de l'adaptateur (2).

5. Elément d'équilibrage de la pression selon la revendication 4, **caractérisé en ce qu'**un système de labyrinthe est prévu dans l'espace intermédiaire entre la surface de fond (3) de l'élément de recouvrement (1) et l'élément de filtre (14), lequel comprend à chaque fois un élément de paroi (19) tourné vers le logement respectif (18), bloquant l'accès direct du logement (18) au centre de l'espace intermédiaire.

6. Elément d'équilibrage de la pression selon la revendication 4 ou 5, **caractérisé en ce qu'**à l'extrémité libre de la paroi (4) de l'élément de recouvrement (1) est prévu au moins un évidement (20) qui est disposé à chaque fois dans le même segment que le logement associé (18).

7. Elément d'équilibrage de la pression selon l'une quelconque des revendications 1 à 6, **caractérisé en ce que** l'élément de filtre (14) est formé par une membrane poreuse (14), perméable à l'air et hydrophobe, et **en ce que** la membrane (14) est supportée par des nervures (9) montées en forme de croix dans l'alésage (5) de l'adaptateur (2).

8. Composant électrique de véhicule automobile, notamment boîtier de transmission (10) d'un moteur d'essuie-glace, qui comprend un élément d'équilibrage de la pression selon la revendication 1 ou 2.

9. Composant électrique de véhicule automobile selon la revendication 8, **caractérisé en ce que** l'élément d'équilibrage de la pression est monté sur un dôme de ventilation (13), le dôme de ventilation (13) présentant une portion (16) orientée vers le composant électrique avec une section transversale intérieure arrondie et une portion vers l'élément d'équilibrage de la pression avec une section transversale intérieure angulaire (17).

10. Composant électrique de véhicule automobile selon la revendication 8, **caractérisé en ce que** l'arbre de sortie sortant du boîtier de transmission (10) du moteur d'essuie-glace est réalisé sous forme d'arbre creux servant à l'équilibrage de la pression du moteur d'essuie-glace, à l'extrémité duquel, qui fait saillie hors du boîtier de transmission (10), est monté l'élément d'équilibrage de la pression.

11. Composant électrique de véhicule automobile selon la revendication 8, **caractérisé en ce que** l'élément d'équilibrage de la pression est monté sur l'ouverture de montage par ajustement serré dans l'alésage d'adaptateur (5), et **en ce que** l'élément d'équilibrage de la pression est réalisé en outre avec un crochet d'encliquetage (21) en tant que pièce conjuguée d'un nez d'encliquetage (22) prévu sur le boîtier (10), le crochet d'encliquetage (21) s'appliquant par engagement par coopération de forme sur le nez d'encliquetage (22).
